Europäisches Patentamt

European Patent Office

Office européen des brevets

(11) Veröffentlichungsnummer: **0 345 508**
**A2**

(12) **EUROPÄISCHE PATENTANMELDUNG**

(21) Anmeldenummer: **89109045.8**

(22) Anmeldetag: **19.05.89**

(51) Int. Cl.⁴: **H05K 3/46**

(30) Priorität: **10.06.88 DE 3819785**

(43) Veröffentlichungstag der Anmeldung:
**13.12.89 Patentblatt 89/50**

(84) Benannte Vertragsstaaten:
**AT DE FR GB IT SE**

(71) Anmelder: **FERROZELL-GESELLSCHAFT SACHS & CO. MBH**
**Theodor-Sachs-Strasse 1**
**D-8900 Augsburg-Inningen(DE)**

(72) Erfinder: **Rilli, Josef**
**Herbststrasse 6b**
**D-8930 Schwabmünchen(DE)**

(74) Vertreter: **Patentanwaltsbüro Cohausz & Florack**
**Postfach 14 01 20 Schumannstrasse 97**
**D-4000 Düsseldorf 1(DE)**

(54) **Verfahren zum Herstellen von mehrlagigen, gedruckten Leiterplatten.**

(57) Die Erfindung bezieht sich auf ein Verfahren zum Herstellen von mehrlagigen, gedruckten Leiterplatten aus mehreren, jeweils mindestens auf einer Seite ein Leiterbild tragenden und zwei Paßlöcher aufweisenden Kernlagen, zwei äußeren leitfähigen Decklagen und jeweils zwischen den Kernlagen und den Decklagen vorgesehenen, gelochten, klebfähigen isolierenden Zwischenlagen (Pregpregs). Zur Ausrichtung der Leiterbilder auf den Kernlagen weisen die Kernlagen jeweils zwei Paßlöcher und die Zwischenlagen korrespondierende Löcher auf. Durch die Paßlöcher der Kernlagen und die Löcher der Zwischenlagen werden zwei Schnüre eingezogen, die auf die Dicke des aus Kernlagen und Zwischenlagen bestehenden Paketes abgelängt werden. Während des Warmverpressens verbleiben diese Schnüre in den Paßlöchern und halten somit die Leiterbilder auf den Kernlagen zueinander ausgerichtet und schützen die Paßlöcher vor einem möglichen Harzfluß aus den Prepregs. Mit dem Verfahren lassen sich beliebig viele Schaltungsebenen in einem Warmpreßvorgang herstellen.

Fig. 2

## Verfahren zum Herstellen von mehrlagigen, gedruckten Leiterplatten

Die Erfindung bezieht sich auf ein Verfahren zum Herstellen von mehrlagigen, gedruckten Leiterplatten aus mehreren, jeweils mindestens auf einer Seite ein Leiterbild tragenden und zwei Paßlöcher aufweisenden Kernlagen, zwei äußeren leitfähigen Decklagen und jeweils zwischen den Kernlagen und den Decklagen vorgesehenen gelochten, klebfähigen, isolierenden Zwischenlagen (Prepregs), deren Löcher mit den Paßlöchern der Kernlagen korrespondieren, durch Warmverpressen zwischen Preßplatten, wobei die Kernlagen während des Warmverpressens durch in die Paßlöcher eingesetzte Paßelemente zueinander ausgerichtet sind.

Beim Herstellen von in mehreren Lagen Leiterbilder tragenden Leiterplatten kommt es darauf an, daß die Leiterbilder in den verschiedenen Ebenen geometrisch exakt zueinander ausgerichtet sind, weil andernfalls wegen eines Lageversatzes beim Durchkontaktieren der einzelnen Leiterbilder ein ausreichender Isolationsabstand nicht gewährleistet ist.

Um diese Forderung zu erfüllen, wird bei einem bekannten Verfahren der eingangs genannten Art (DE-OS 1 640 934), dem sogenannten Pin-Laminieren, die Ausrichtung der einzelnen Leiterbilder tragenden Kernlagen mittels der als Zentrierstifte ausgebildeten Paßelemente vorgenommen, die nicht nur die Paßlöcher und die Löcher in den Zwischenlagen, sondern auch Löcher in den Decklagen durchgreifen und in Löcher der Preßplatten eingreifen. Beim Wamverpressen eines solchen Paketes aus Kernlagen, Zwischenlagen und Decklagen zwischen den Preßplatten, gelangt aus den Zwischenlagen Harz auch in den Bereich der Löcher und an die Stifte und im Bereich der Löcher an die Preßplatten. Dieses Pin-Laminierverfahren ist arbeitsaufwendig, weil die Preßplatten und die Stifte von dem sie gelangten Harz gereinigt werden müssen, bevor sie wieder verwendet werden können. Hinzu kommt, daß der Hersteller von Leiterplatten für verschiedene Abnehmer, die nach individuellen Bedürfnissen die Lage der Paßlöcher vorgeben, Preßbleche verwenden muß, die Löcher für Paßstifte mit entsprechender Lage haben. Das bedeutet, daß diese Hersteller eine Vielzahl von unterschiedlichen Preßblechen für die Fertigung der verschiedenen Leiterplatten bereitstellen müssen.

Um diesen Schwierigkeiten aus dem Wege zu gehen, wird seit längerem ein optisches Justierverfahren praktiziert. Bei diesem Verfahren werden auf die Kernlage optische Justiermarken, z.B. Fadenkreuze oder Ringe, durch Belichten der fotosensitiven Schicht und anschließendes Abätzen der nicht abgedecken Kupferfolie aufgebracht. Diese Markierungen dienen als optische Referenzmarke bei der Ausrichtung der Platten in der Bohrmaschine. Damit beim Verpressen der im Bereich der Markierungen gelochten Prepregs und Kupferfolien die Markierungen nicht durch das aus den Prepregs beim Verpressen herausgedrückte Harz zugedeckt werden, können die Markierungen durch in die Löcher der Prepregs und der Kupferfolie eingesetzte Plättchen abgedeckt werden (DE-OS 2 917 472; DE-OS 3 144 849).

Es hat sich nun gezeigt, daß auch diese optischen Ausrichtverfahren nicht mehr den zunehmenden Anforderungen an die Deckungsgenauigkeit der verschiedenen Leiterbilder, insbesondere bei sehr vielen übereinanderliegenden Leiterbildern, genügen.

Um die geschilderten Schwierigkeiten beim Pin-Laminieren zu vermeiden, ist ein Verfahren nach dem Relam-Prinzip bekannt (DE 35 18 919 A1). Bei diesem Verfahren sind in der auf einer oder beiden Seiten ein Leiterbild tragenden Kernlage Paßlöcher vorgesehen, die als Referenzlöcher bei der Erstellung der Leiterbilder in den weiteren Lagen dienen. Damit diese Paßlöcher beim gegebenenfalls wiederholten Warmverpressen ihre Form behalten, ist es bekannt, in die Paßlöcher Stopfen aus elastischem Material einzusetzen, die die Ränder der Kernlage vor beim Warmverpressen stattfindendem Harzfluß aus den Prepregs schützen. Nach Entfernen der Stopfen aus den Paßlöchern, was gegebenenfalls erst nach Entfernen des die Paßlöcher abdeckenden Teils der Decklagen möglich ist, werden die maßgetreuen Paßlöcher für die Herstellung des in Foto-Ätztechnik zu erstellenden Leiterbildes aus der leitfähigen Beschichtung der Decklagen verwendet. Dadurch ist eine exakte Ausrichtung dieses Leiterbildes zu dem oder den Leiterbildern der Kernlage gewährleistet. Wird eine Leiterplatte mit mehr als vier Ebenen verlangt, werden nach Einsetzen von neuen Stopfen in die Paßlöcher gelochte klebfähige Zwischenlagen und Decklagen mit außen leitfähiger Beschichtung aufgebracht, die dann erneut warmverpreßt werden, um anschließend aus den leitfähigen Beschichtungen die gewünschten Leiterbilder herzustellen.

Bei diesem Verfahren nach dem Relam-Prinzip sorgen die in die Paßlöcher eingesetzten Stopfen nur dafür, die Ränder der Paßlöcher von Harz freizuhalten. Den Stopfen kommt keine Ausrichtfunktion zu. Ein Schwimmen der Kernlagen beim Warmverpressen ist unkritisch, weil beim Warmverpressen der mindestens ein Leiterbild tragenden Kernlage die Decklage noch kein Leiterbild trägt. Nachteilig bei dem Relam-Verfahren ist, daß bei einer Vielzahl von Lagen wiederholt eine Warmverpressung der nacheinander aufzubringenden Lagen notwendig ist.

Der Erfindung liegt die Aufgabe zugrunde, ein Verfahren zum Herstellen von mehrlagigen, gedruckten Leiterplatten mit mehr als vier Schaltungsebenen nach der Pin-Laminiermethode zu entwickeln, das im Vergleich zum herkömmlichen Verfahren weniger aufwendig ist.

Diese Aufgabe wird bei einem Verfahren der eingangs genannten Art dadurch gelöst, daß ungelochte Decklagen verwendet werden und daß vor dem Aufbringen dieser Decklagen durch die Paßlöcher der Kernlagen und die Löcher der zwischen den Kernlagen und den Decklagen vorgesehenen Zwischenlagen auf die Dicke des aus den Kernlagen und den Zwischenlagen bestehenden Paketes abzulängende, als Paßelemente dienende, hitzebeständige Schnüre eingezogen werden, die beim späteren Warmverpressen stirnseitig an den ungelochten Decklagen anliegen und nach Entfernen der Decklagen im Bereich der Paßlächer aus den Paßlöchern entfernt werden.

Bei dem erfindungsgemäßen Verfahren werden die Leiterbilder auf sämtlichen Kernlagen unabhängig voneinander hergestellt. Da die Leiterbilder zu den Paßlöchern ausgerichtet sind, ergeben sich für alle Leiterbilder gemeinsame Referenzlöcher, die von den in die Paßlöcher eingezogenen Schnüren zur genauen Ausrichtung der Leiterbilder gegeneinander benutzt werden. Da die Schnüre stirnseitig beim Warmverpressen an den ungelochten Decklagen anliegen, ist nicht nur eine Fixierung und Pressung der Schnüre gegeben, sondern gleichzeitig wird verhindert, daß die Preßbleche und die Ränder der Paßlöcher von herausgedrücktem Harz verschmutzt werden. Ein weiterer Vorteil der Erfindung ist, daß auf gelochte Preßbleche verzichtet wird. Deshalb ist das erfindungsgemäße Verfahren unabhängig vom vom jeweiligen Hersteller vorgegebenen Format, das heißt, mit denselben Preßblechen lassen sich unterschiedlichste Formate herstellen. Nach dem Warmverpressen und Entfernen der die Schnüre abdeckenden Bereiche der Decklagen werden die Schnüre entfernt, so daß die dann freiliegenden, während des Warmverpressens durch die Schnüre geschützten Paßlöcher als Referenzlöcher beim Foto-Ätzen der Leiterbilder in der leitfähigen äußeren Beschichtung und beim Durchbohren des aus Kern-, Zwischen- und Decklagen bestehenden verpreßten Paketes für die Durchkontaktierung herangezogen werden können. Der große Vorteil dieses Verfahrens gegenüber dem Relam-Verfahren besteht somit darin, daß beliebig viele Lagen mit Leiterbildern in einem einzigen Verfahrensschritt durch Warmverpressen bei exakter Ausrichtung der einzelnen Leiterbilder zueinander hergestellt werden können.

Der Vorteil des erfindungsgemäßen Verfahrens gegenüber dem Verfahren, bei dem metallene Paßstifte verwendet werden, besteht darin, daß keine gelochten Preßplatten für die Aufnahme der metallenen Paßstifte benötigt werden. Die Paßlöcher bei den nach dem erfindungsgemäßen Verfahren hergestellten Leiterplatten können nach den individuellen Bedürfnissen der Anwender positioniert werden. Um den Paketaufbau aus den einzelnen Lagen zu erleichtern, sollte das Ablängen der Schnüre erst nach dem Einziehen in die Paßlöcher und Löcher erfolgen.

Untersuchungen an einer nach dem erfindungsgemäßen Prinzip hergestellten Leiterplatte haben ergeben, daß die elastischen Schnüre den Lagenversatz im My-Bereich halten. Der Lagenversatz ist besonders gering, wenn Schnüre mit einem Übermaß gegenüber den Abmessungen der Paßlöcher verwendet werden, die zum Einziehen in die Paßlöcher der mit den Zwischenlagen ein Paket bildenden Kernlagen gedehnt und beim Einziehen gedehnt gehalten werden. Bei dieser Ausgestaltung werden nämlich aufgrund der im Bereich der Paßlöcher nach Entspannen verbleibenden Vorspannung die einzelnen Lagen durch die Schnüre ausgerichtet und darüber hinaus noch die einzelnen Lagen gegeneinander gezogen. Im Bereich der Zwischenlagen bauchen sich die Schnüre ein wenig aus, so daß sie die Ränder der Platten vor Harzfluß gut schützen. Als geeignet wurde ein Übermaß von 10 bis 30 % für die Schnüre ermittelt.

Schließlich hat sich für das maßgenaue Ausgerichtethalten der Kernlagen und Schutz der Paßlöcher bewährt, wenn die Schnüre auf beiden Seiten des verpreßten Paketes mit einem Überstand von 0,5 bis 1 mm abgelängt werden.

Im folgenden wird die Erfindung anhand einer Zeichnung näher erläutert. Im einzelnen zeigen:

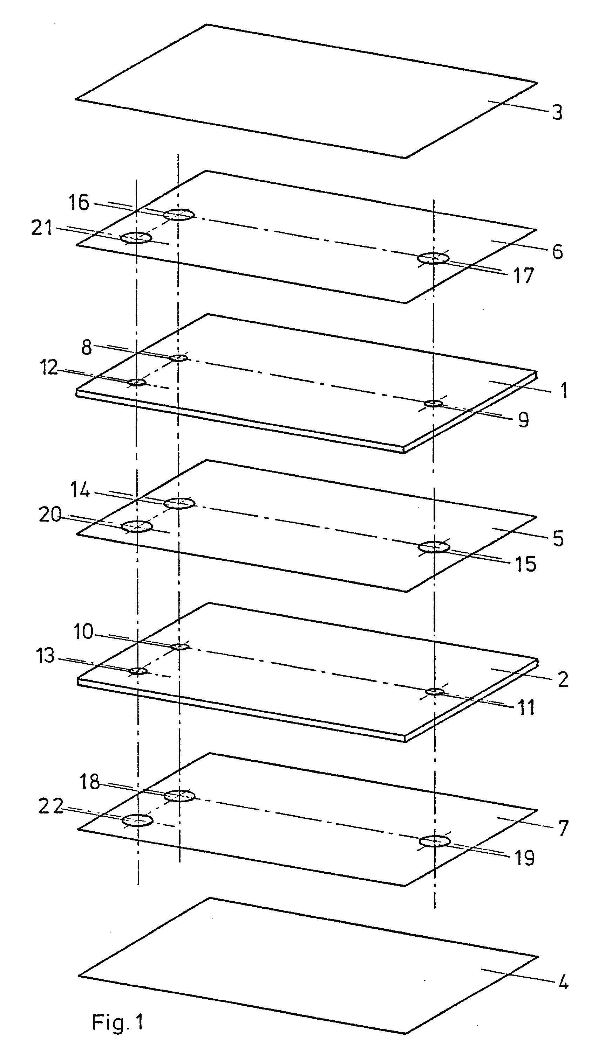

Fig. 1 die einzelnen Lagen der Leiterplatte vor dem Übereinanderschichten und

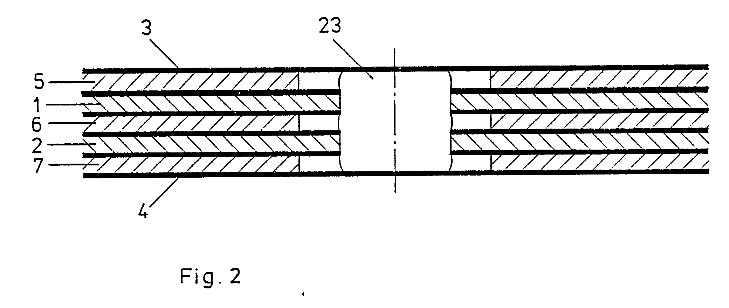

Fig. 2 die Leiterplatte im Bereich der Paßlöcher im Querschnitt.

Die in der Zeichnung dargestellte Leiterplatte besteht aus zwei Kernlagen 1,2 und zwei Decklagen 3,4 sowie zwischen den Kernlagen 1,2 und den Decklagen 3,4 angeordneten klebfähigen Zwischenlagen (Prepregs) 5 bis 7.

Die Kernlagen 1,2 tragen auf beiden Seiten jeweils ein Schaltungsbild. Diese Schaltungsbilder sind zu Paßlöchern 8 bis 11 und Kennlöchern 12,13 ausgerichtet. Dadurch wird gewährleistet, daß bei Ausrichtung der Paßlöcher 8 bis 11 auch die Leiterbilder der beiden Kernlagen 1,2 zueinander ausgerichtet sind.

In den Zwischenlagen 5 bis 7 sind mit den Paßlöchern 11 und den Kennlöchern 12,13 korrespondierende, aber im Durchmesser größere Löcher 14 bis 22 vorgesehen.

Die ungelochten Decklagen 3,4 sind leitfähige Folien, insbesondere aus Kupfer. Die Isolierung gegenüber dem Leiterbild der darunterliegenden Kernlage 1,2 wird nämlich durch die jeweilige Zwischenlage 6,7 bewirkt.

Der Aufbau der Leiterplatte erfolgt in der Weise, daß bei grober Ausrichtung der Löcher 8 bis 22, 14 bis 19 der lose übereinandergeschichteten Kernlagen 1,2 und Zwischenlagen 5 bis 7 als Paßelemente ausgebildet Schnüre 23 aus hitzebeständigem, elastischem Material, zum Beispiel Silikonkautschuk, eingezogen werden. Dazu werden die ein Übermaß gegenüber den Paß- und Kennlöchern 8 bis 13 aufweisende Schnüre so weit gedehnt, daß sie leicht in die Paß- und Kennlöcher 8 bis 13 eingezogen werden können. Beim Entspannen ziehen sich die Schnüre 23 in Längsrichtung zusammen und expandieren radial. Dadurch werden einerseits die einzelnen Lagen aufeinandergezogen und andererseits legen sich die Schnüre 23 fest an die Innenwände der Paß-und Kennlöcher 8 bis 13 an, wobei sie sich sogar im Bereich der größeren Löcher der Prepregs 5,6,7 leicht ausbauchen, so daß die Paß- und Kennlöcher 8 bis 13 gut vor unerwünschtem Harzfluß geschützt sind. Diese Schnüre 23 werden nach dem Einziehen auf die Dicke des sich aus den Lagen 1,2,5-7 zusammensetzenden Paketes abgelängt. Dann werden die Decklagen 3,4 aufgebracht, an deren Innenseiten sich die Stirnseiten der abgelängten Schnüre 23 anlegen. Anschließend wird das gesamte Paket zwischen ungelochten Preßplatten warmverpreßt. Bei diesem Warmverpressen halten die elastischen, aber hitzebeständigen Schnüre 23 die Kernlagen 1,2 zueinander in der gewünschten ausgerichteten Position, wobei die Schnüre 23 zusätzlich durch das stirnseitige Anliegen an den Innenseiten der Decklagen 3,4 fixiert gehalten werden. Die Schnüre 23 halten aber nicht nur die Kernlagen 1,2 in ihrer relativen Lage, sondern halten auch die Paßlöcher 8-11 von einem eventuellen Harzfluß aus den Zwischenlagen 5-7 frei, so daß die Paßlöcher 8-11 nach Entfernen der sie abdeckenden Bereiche der Decklagen 3,4 bei der Herstellung der Leiterbilder in der äußeren Kupferfolie 24,25 als Referenzmarken herangezogen werden können.

## Ansprüche

1. Verfahren zum Herstellen von mehrlagigen, gedruckten Leiterplatten aus mehreren, jeweils mindestens auf einer Seite ein Leiterbild tragenden und zwei Paßlöcher aufweisenden Kernlagen, zwei äußeren leitfähigen Decklagen und jeweils zwischen den Kernlagen und den Decklagen vorgesehenen, gelochten, klebfähigen, isolierenden Zwischenlagen (Prepregs), deren Löcher mit den Paßlöchern der Kernlagen korrespondieren, durch Warmverpressen zwischen Preßplatten, wobei die Kernlagen während des Warmverpressens durch in die Paßlöcher eingesetzte Paßelemente zueinander ausgerichtet sind,

dadurch gekennzeichnet, daß ungelochte Decklagen verwendet werden und daß vor dem Aufbringen dieser Decklagen durch die Paßlöcher der Kernlagen und die Löcher der zwischen den Kernlagen und den Decklagen vorgesehenen Zwischenlagen auf die Dicke des aus den Kernlagen und den Zwischenlagen bestehenden Paketes abzulängende, als Paßelemente dienende, hitzebeständige Schnüre eingezogen werden, die beim späteren Warmverpressen stirnseitig an den ungelochten Decklagen anliegen und nach Entfernen der Decklagen im Bereich der Paßlöcher aus den Paßlöchern entfernt werden.

2. Verfahren nach Anspruch 1,
dadurch gekennzeichnet, daß das Ablängen der Schnüre nach dem Einziehen in die Paßlöcher und Löcher erfolgt.

3. Verfahren nach Anspruch 1 oder 2,
dadurch gekennzeichnet, daß Schnüre mit einem Übermaß gegenüber den Abmessungen der Paßlöcher verwendet werden, die zum Einziehen in die Paßlöcher der mit den Zwischenlagen ein Paket bildenden Kernlagen gedehnt und beim Einziehen gedehnt gehalten werden.

4. Verfahren nach Anspruch 3,
dadurch gekennzeichnet, daß für die Schnüre ein Übermaß von 10 % bis 30 % gewählt wird.

5. Verfahren nach einem der Ansprüche 1 bis 4,
dadurch gekennzeichnet, daß die Schnüre auf beiden Seiten mit einem Überstand von 0,5 mm bis 1 mm gegenüber dem verpreßten Paket abgelängt werden.

Fig. 1

Fig. 2